# FASCICULE DE BREVET EUROPEEN

(11) **EP 3 267 493 B1**
(45) Date de publication et mention de la délivrance du brevet: **15.05.2019**
(21) Numéro de dépôt: 17179780.6
(22) Date de dépôt: 05.07.2017
(51) Int. Cl.: H01L 31/107

(54) **STRUCTURE DU TYPE PHOTODIODE À AVALANCHE ET PROCÉDÉ DE FABRICATION D'UNE TELLE STRUCTURE**
STRUKTUR VOM TYP LAWINENFOTODIODE, UND HERSTELLUNGSVERFAHREN EINER SOLCHEN STRUKTUR
AVALANCHE PHOTODIODE STRUCTURE AND METHOD FOR MANUFACTURING SUCH A STRUCTURE

(30) Priorité: 08.07.2016 FR 1656581
(43) Date de publication de la demande: 10.01.2018
(73) Titulaire: Commissariat à l'énergie atomique et aux énergies alternatives, 75015 Paris (FR)
(72) Inventeur: ROTHMAN, Johan, 38000 GRENOBLE (FR)
(74) Mandataire: Brevalex

(56) Documents cités:
- US-A- 5 654 578
- US-A1- 2016 172 525
- MASAHIRO NADA ET AL: "Linearity improvement of high-speed avalanche photodiodes using thin depleted absorber operating with higher order modulation format", OPTICS EXPRESS, vol. 23, no. 21, 13 octobre 2015 (2015-10-13), page 27715, XP055367709, DOI: 10.1364/OE.23.027715

## Description

### DOMAINE TECHNIQUE

L'invention concerne les photodiodes à avalanche et a plus précisément pour objet les photodiodes à avalanche adaptées pour fonctionner dans la gamme des hyperfréquences.

### ÉTAT DE LA TECHNIQUE ANTÉRIEURE

L'industrie optoélectronique est actuellement à la recherche de photodiodes à avalanche permettant de recevoir un signal optique modulé dans les gammes des hyperfréquences. En effet, les photodiodes à avalanche présentent généralement une bande passante qui est limitée par leur temps de réponse et ne sont donc pas aptes à percevoir des modulations de signaux optiques dans la gamme des hyperfréquences.

Par modulation dans la gamme des hyperfréquences, il doit être entendu ici et dans le reste de ce document, les modulations de signaux optique avec une fréquence supérieur ou égale à 1 GHz, celle-ci pouvant aller de 1 GHz jusqu'à 10 GHz, ou voire de 1 GHz, ou encore de 1 GHz jusqu 'à 100 GHz, voire de 1 GHz jusqu'à 200 GHz.

Pour améliorer la bande passante des photodiodes à avalanche, il est connu des travaux de Ning Duan et de ses co-auteurs publiés dans la revue scientifique « I.E.E.E Photonics Technology Letters » volume 17, numéro 8, pages 1719 à 1721 en 2005, d'intégrer, en amont et en aval de la couche d'absorption, des couches supplémentaires pour accélérer l'injection des porteurs générés lors de l'absorption.

Ainsi, la structure du type photodiode divulguée par Ning Duan, celle-ci étant destinée à recevoir un rayonnement électromagnétique dans une première gamme de longueurs d'onde, comporte :
- une première zone amont dopée P présentant une bande interdite pour être transparente à la première gamme de longueurs d'onde (couches d'InAlAs notées P+),
- une deuxième zone semiconductrice, dite d'absorption, également dopé P avec une concentration en porteurs plus faible que celle de la première zone, le matériau semiconducteur dans lequel est formée ladite deuxième zone présentant une largeur de bande interdite adaptée pour favoriser l'absorption du rayonnement électromagnétique (couche InGaAs),
- une troisième zone de charge dopée P avec une concentration en porteurs majoritaires supérieure à celle de la deuxième zone, ladite troisième zone comportant une première et une deuxième couche respective d'InAlAs and d'InGaAlAs,
- une quatrième zone semiconductrice, dite de multiplication, comprenant deux couches d'InGaAlAs et d'InAlAs non intentionnellement dopées, la troisième zone participant également à la multiplication,
- une cinquième zone semiconductrice, dite de collecte, ladite cinquième zone étant dopée N.

Ainsi cette structure se différencie d'une structure du type photodiode à avalanche de par la présence de la première et la troisième zone qui permettent de générer un champ électrique pour accélérer l'injection dans la zone de multiplication les porteurs générés dans la couche d'absorption lors de la réception d'un rayonnement électromagnétique.

Une telle structure présente ainsi un temps de réponse optimisé et permet d'augmenter significativement la bande passante vis-à-vis d'une structure classique puisqu'elle permet d'envisager l'utilisation de signaux optiques modulés à des fréquences pouvant être supérieures à 10 GHz. Une telle structure ne permet pas d'atteindre des gains réellement significatifs, c'est-à-dire supérieures à 10, pour des signaux optiques modulés à des fréquences supérieures à 10 GHz. On notera de plus qu'une telle structure présente une bande passante variable en fonction du gain et donc que cette fréquence de 10 GHz ne peut être atteinte que pour des gains relativement faibles, ce qui en limite les applications.

En parallèle aux travaux de Ning Duan et de ses co-auteurs, on peut également citer les travaux portant sur les structures du type photodiodes à avalanche à multiplication d'un type de porteurs donné. Ces structures présentent une configuration telle que seuls les porteurs d'un seul type, généralement les électrons, sont multipliés lors de leurs passages dans la zone de multiplication. Les travaux de J. Rothman et de ses co-auteurs publiés dans la revue scientifique « Journal of Electronic Material » volume 43 numéro 8 pages 2947-2954 en 2014 ont permis de montrer que cette multiplication de porteurs sélective permet d'obtenir de fort gain sans que la bande passante ne soit négativement influencée. Ainsi, il est possible d'obtenir avec de telles structures des bandes passantes importantes même pour des forts gains.

La bande passante de ces structures à multiplication sélective reste néanmoins trop faible pour les applications hyperfréquence. En effet, comme l'ont montré J.Rothman et ses co-auteurs, il n'est actuellement pas possible d'envisager avec de telles structures l'utilisation de signaux optiques modulés à des fréquences supérieures à 10 à 20 GHz.

Les travaux de Masahiro Nada et co-auteurs "Linearity improvement of high-speed avalanche photodiodes using thin depleted absorber operating with higher order modulation format" publiés dans Optics Express Vol. 23, No. 21, 27715-27723 décrivent une photodiode à avalanche comprenant des couches de contrôle de champs.

### EXPOSÉ DE L'INVENTION

L'invention vise à remédier à ces inconvénients et a ainsi pour but de fournir une structure du type photodiode à avalanche apte à recevoir des signaux optiques avec des modulations à des fréquences comprises dans la gamme des hyperfréquences ceci avec un gain significatif afin d'autoriser des applications pratiques dans la gamme des hyperfréquences.

L'invention concerne à cet effet une structure du type photodiode à avalanche destinée à recevoir un rayonnement électromagnétique dans une première gamme de longueurs d'onde, la structure comportant :
- une première zone semiconductrice d'un premier type de conductivité présentant une première face destinée à recevoir le rayonnement électromagnétique et une seconde face opposée à la première face, ,
- une deuxième zone semiconductrice, dite de multiplication, en contact avec la seconde face de la première zone semiconductrice et présentant une concentration en porteurs majoritaires inférieure à celle de la première zone semiconductrice, la deuxième zone semiconductrice étant conformée pour fournir une multiplication de porteurs par ionisation par impact qui est prépondérante pour les électrons,
- une quatrième zone semiconductrice, dite de collecte, la quatrième zone semiconductrice étant d'un deuxième type de conductivité pour lequel les porteurs majoritaires sont les électrons et présentant une concentration en porteurs majoritaires supérieure que celle de la deuxième zone semiconductrice,
au moins l'une de la première et la deuxième zone semiconductrice étant formée dans un matériau semiconducteur présentant une largeur de bande interdite adaptée pour favoriser l'absorption du rayonnement électromagnétique,
la structure comprenant en outre une troisième et une cinquième zone semiconductrice agencées entre la deuxième zone semiconductrice et la quatrième zone semiconductrice, la troisième zone semiconductrice comportant une concentration en porteurs majoritaires inférieure à celle des première, quatrième et cinquième zones semiconductrices, la cinquième zone semiconductrice étant du deuxième type de conductivité et comportant une concentration en porteurs majoritaires supérieure à celle de la deuxième zone semiconductrice de telle manière à créer dans la troisième zone semiconductrice un champ électrique sans multiplication de porteurs par ionisation par impact.

Avec un tel champ électrique dans la troisième zone semiconductrice, la dérive des électrons dans la troisième zone est beaucoup plus importante que dans celle de la zone semiconductrice de multiplication qui est fortement réduite en raison de la multiplication de porteurs. Une telle dérive rapide des électrons dans la troisième zone semiconductrice permet d'accélérer la séparation des charges dans la jonction et, par conséquence, l'évacuation de charges et la fourniture d'une réponse électronique dominée par la contribution des électrons. Or cette contribution des électrons étant supérieure en vitesse à celle des trous d'un facteur au moins 3, l'augmentation de la bande passante de la structure vis-à-vis de l'art antérieur est significative. Cette bande passante augmentée n'est, de plus, pas dégradée par un gain en multiplication important, puisque la zone de multiplication de la structure est adaptée pour offrir une multiplication de porteurs par ionisation par impact prépondérante pour les électrons.

Une telle structure permet donc d'envisager les applications hyperfréquences en raison de son temps de réponse optimisé même pour des gains élevés.

On entend ci-dessus et dans le reste de ce document, par « multiplication de porteurs par ionisation par impact qui est prépondérante pour un type de porteurs » que la multiplication de porteurs par ionisation par impact de l'un des types de porteurs est négligeable vis-à-vis de la multiplication de porteurs par ionisation par impact de l'autre type de porteurs, c'est à dire que le rapport entre les deux taux de multiplication est supérieur à 10, préférentiellement 100, voire 1000.

Bien entendu, la structure est considérée, ci-dessus et dans le reste de ce document, en fonctionnement lorsqu'elle est soumise à une polarisation comprise dans une plage de tension nominale de fonctionnement, telle qu'une polarisation comprise entre 5 V et 15 V, voire entre 11 V et 13 V.

La deuxième zone semiconductrice peut être formée dans le matériau semiconducteur qui présente une largeur de bande interdite adaptée pour favoriser l'absorption du rayonnement électromagnétique.

Avec une telle configuration, l'absorption et la multiplication de porteurs ayant lieu dans la même zone semiconductrice, le temps de réponse, et donc la bande passante de la structure, sont particulièrement optimisés.

La première zone semiconductrice peut être formée dans le matériau semiconducteur qui présente une largeur de bande interdite adaptée pour favoriser l'absorption du rayonnement électromagnétique.

Une telle structure présente un bruit de multiplication contenu puisque l'absorption de photons et la multiplication de porteurs sont séparées, tout étant apte à recevoir des signaux optiques avec des modulations à des fréquences comprises dans la gamme des hyperfréquences, puisqu'elle bénéficie des avantages liés à l'invention.

La cinquième zone semiconductrice peut comporter une concentration en porteurs majoritaires adaptée pour que la cinquième zone semiconductrice soit déplétée en fonctionnement de la structure.

De cette manière, il est possible de générer un champ électrique suffisant dans la troisième zone semiconductrice pour optimiser la dérive des électrons avec une épaisseur de la cinquième zone semiconductrice relativement faible. Le temps de réponse de la structure peut ainsi être peu, voire pas, influencé par la présence de la cinquième zone semiconductrice.

On entend ci-dessus et dans le reste de ce document par zone semiconductrice déplétée le fait que cette dernière zone ait été vidée de ces porteurs en raison du champ électrique présent dans la structure, de telles zones semiconductrices déplétées étant généralement associée à une zone de charge d'espace de la structure.

La troisième zone semiconductrice peut être du deuxième type de conductivité.

La deuxième zone semiconductrice peut être du deuxième type de conductivité.

La structure peut comporter en outre une jonction semiconductrice qui s'étend selon un plan de jonction, la deuxième et la troisième zone semiconductrice comportant chacune une épaisseur selon une direction transversale audit plan de jonction, et
l'épaisseur de la troisième zone semiconductrice peut être supérieure à celle de la deuxième zone semiconductrice, l'épaisseur de la troisième zone semiconductrice étant préférentiellement supérieure à deux fois celle de la deuxième zone semiconductrice.

Avec une telle épaisseur de la troisième zone semiconductrice, l'infliuence de la dérive optimisée des électrons sur toute l'épaisseur de la troisième zone semiconductrice est significative sur le temps de réponse de la structure et permet de compenser le temps de parcours des porteurs dans la deuxième zone semiconductrice.

Par épaisseur d'une zone semiconductrice, il doit être entendu, ci-dessus et dans le reste de ce document, la dimension moyenne d'une zone semiconductrice selon une direction sensiblement transversale à la jonction de la structure.
la troisième zone semiconductrice peut comporter une largeur de bande interdite inférieure à celle du matériau semiconducteur présentant une largeur de bande interdite adaptée pour favoriser l'absorption du rayonnement électromagnétique dans lequel au moins l'une de la première et la deuxième zone semiconductrice est formée, la troisième zone semiconductrice comportant préférentiellement une largeur de bande interdite inférieure à celle des première, deuxième, quatrième et cinquième zone semiconductric.

Avec une largeur de bande interdite relativement faible vis-à-vis de celle de la première zone semiconductrice, la vitesse de saturation des électrons dans la troisième zone semiconductrice s'en trouve optimisée vis-à-vis de celle dans la première zone semiconductrice et dans la deuxième zone semiconductrice.

La première et la deuxième zone semiconductrice peuvent être intégrées à une couche semiconductrice, la couche semiconductrice comportant une première face et une deuxième face, une première portion de la couche semiconductrice s'étendant à partir d'une partie de la première face formant la première zone semiconductrice, le reste de la couche semiconductrice formant la deuxième zone semiconductrice.

La troisième et la quatrième zone semiconductrice peuvent être intégrées à une couche semiconductrice, la couche semiconductrice comportant une première portion formant la quatrième zone semiconductrice et le reste de la couche semiconductrice formant la troisième zone semiconductrice.

De tels ménagements de deux zones semiconductrices dans une couche semiconductrice permettent de délimiter spatialement la structure sans nécessiter une opération de gravure telle que l'aménagement d'une mesa.

Chacune de la première à la cinquième zone semiconductrice peut être formée par une couche semiconductrice respective, les zones semiconductrices étant mises en contact les une avec les autres par les faces des couches semiconductrices les formant.

Une telle structure planaire présente l'avantage d'être aisée à fabriquer, la structure pouvant être fabriquée par un dépôt successif des couches formants chacune des zones semiconductrices.

Au moins une partie des couches semiconductrices formant des première à la cinquième zones semiconductrices peuvent être délimitée spatialement par les parois d'une mesa.

Une telle délimitation spatial par les parois d'une mesa permet de supprimer tout risque de diaphonie et permet également de contrôler les zones actives de la structure dans lesquelles du bruit est susceptible d'être généré.

L'invention concerne en outre un procédé de fabrication d'une structure du type photodiode à avalanche, le procédé comprenant les étapes suivantes de :
- fourniture d'une première zone semiconductrice d'un premier type de conductivité pour lequel les porteurs majoritaires sont les électrons, et présentant une première face destinée à recevoir le rayonnement électromagnétique et une seconde face opposée à la première face,
- fourniture d'une deuxième zone semiconductrice, dite de multiplication, la deuxième zone semiconductrice présentant une concentration en porteurs majoritaires inférieure à celle de la première zone semiconductrice, ladite deuxième zone semiconductrice étant adaptée pour fournir une multiplication de porteurs par ionisation par impact qui est prépondérante pour les électrons, les étapes de fourniture de la première et de la deuxième zone semiconductrice étant réalisées de manière à ce que la deuxième zone semiconductrice soit en contact avec la seconde face de la première zone semiconductrice, au moins l'une de la première et la deuxième zone semiconductrice étant formée dans un matériau semiconducteur présentant une largeur de bande interdite adaptée pour favoriser l'absorption du rayonnement électromagnétique,
- fourniture d'une troisième zone semiconductrice et une cinquième zone semiconductrice,
- fourniture d'une quatrième zone semiconductrice, dite de collecte, ladite quatrième zone semiconductrice étant d'un deuxième type de conductivité pour lequel les porteurs majoritaires sont les électrons, et présentant une concentration en porteurs majoritaires supérieure à celle de la deuxième zone semiconductrice,
dans lequel les étapes de fourniture de la troisième et de la cinquième zone semiconductrice étant réalisées de manière que les troisième et de la cinquième zones semiconductrices soient agencées entre la deuxième zone semiconductrice et la quatrième zone semiconductrice, la troisième zone semiconductrice comportant une concentration en porteurs majoritaires inférieure à celle des première, quatrième et cinquième zones semiconductrices et la cinquième zone semiconductrice étant du deuxième type de conductivité et comportant une concentration en porteurs majoritaires supérieure à celle de la deuxième zone semiconductrice de tel manière à créer dans la troisième zone semiconductrice un champ électrique sans multiplication de porteurs par ionisation par impact.

Un tel procédé permet la fabrication d'une structure bénéficiant des avantages liés à l'invention.

L'étape de fourniture de la première zone peut être préalable aux étapes de fourniture de la deuxième, de la troisième, de la quatrième et de la cinquième zone semiconductrice,
les étapes respectives et successives de fourniture des deuxième, cinquième, troisième et quatrième zones semiconductrices consistant chacune en une étape de formation de ladite zone en contact de la zone semiconductrice formée précédemment, la deuxième zone semiconductrice étant formée en contact avec la première zone semiconductrice.

L'étape de fourniture de la quatrième zone peut être préalable aux étapes de fourniture de la première, deuxième, troisième et cinquième zone semiconductrice,
les étapes respectives et successives de fourniture des troisième, éventuelle cinquième, deuxième et première zones semiconductrices consistant chacune en une étape de formation de ladite zone en contact de la zone semiconductrice formée précédemment, la troisième zone semiconductrice étant formée en contact avec la quatrième zone semiconductrice.

De tels procédés permettent de fabriquer de manière simple une structure bénéficiant des avantages liés à l'invention.

### BRÈVE DESCRIPTION DES DESSINS

La présente invention sera mieux comprise à la lecture de la description d'exemples de réalisation, donnés à titre purement indicatif et nullement limitatif, en faisant référence aux dessins annexés sur lesquels :
- la figure 1 est une coupe schématique de principe d'une structure selon un premier mode de réalisation de l'invention mise en parallèle avec les variations du champ électrique et de la largeur de bande interdite le long de son épaisseur,
- les figures 2A et 2B illustrent respectivement la courbe de réponse électronique normalisée d'une structure de l'art antérieur et celle d'une structure selon le premier mode de réalisation de l'invention,
- la figure 3 illustre schématiquement une conception pratique de la structure illustrée sur la figure 1 dans laquelle la structure est inscrite dans une mesa,
- la figure 4 illustre schématiquement une deuxième conception pratique de la structure illustrée sur la figure 1 dans laquelle la structure est planaire,
- la figure 5 est une coupe schématique de principe d'une structure selon un second mode de réalisation de l'invention mise en parallèle avec les variations du champ électrique et de la largeur de bande interdite le long de son épaisseur,
- la figure 6 illustre la courbe de réponse électronique normalisée d'une structure selon le deuxième mode de réalisation,
- la figure 7 illustre une coupe schématique de principe d'une structure selon un troisième mode de réalisation de l'invention dans lequel les zones semiconductrices d'absorption et de multiplication sont confondues.

Des parties identiques, similaires ou équivalentes des différentes figures portent les mêmes références numériques de façon à faciliter le passage d'une figure à l'autre.

Les différentes parties représentées sur les figures ne sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

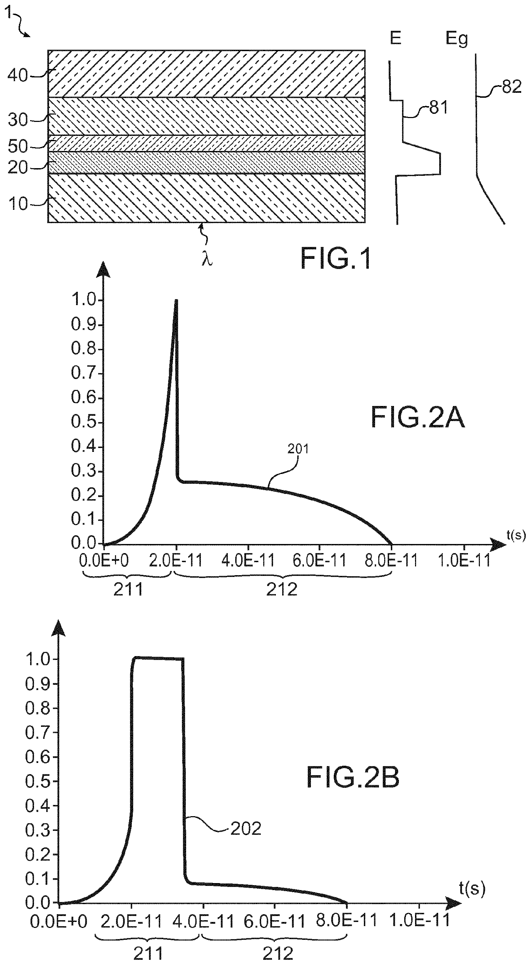

La figure 1 illustre schématiquement une structure 1 du type photodiode à avalanche selon un premier mode de réalisation de l'invention qui est apte à recevoir des signaux optiques modulés dans la gamme des hyperfréquences. De tels signaux optiques sont des rayonnements électromagnétiques dans une gamme de longueurs d'onde présentant une intensité variée à une fréquence comprise dans la gamme des hyperfréquences, cette variation étant généralement représentative d'informations à recevoir.

L'invention concerne principalement les structures du type photodiode à avalanche pour lesquelles la multiplication de porteurs par ionisation par impact est prépondérante pour un seul type de porteurs, les électrons. Lors de la conception des structures décrites dans les modes de réalisation suivants, le choix du matériau a porté sur les tellurures de mercure-cadmium du type CdₓHg₁₋ₓTe. Dans de telles structures, le premier type de conductivité correspond au type de conductivité pour lequel les porteurs majoritaires sont les trous, c'est-à-dire au dopage P, tandis que le deuxième type de conductivité correspond au type de conductivité pour lequel les porteurs majoritaires sont les électrons, c'est-à-dire au dopage N.

On peut noter que la terminologie de « tellurure de mercure-cadmium » utilisée ci-dessus et dans le reste de ce document doit être entendue comme correspondant aux composés comprenant le tellure et au moins un élément choisi parmi le cadmium et le mercure tel que les composés respectant la formulation suivante CdₓHg₁₋ₓTe avec la valeur x correspondant à la proportion de cadmium par rapport au mercure et est donc comprise entre 1 et 0, 1 et 0 inclus.

Néanmoins, l'invention ne se limite pas aux seules structures réalisées à partir des tellurures de mercure-cadmium et englobe également tout type de structure dont la conception permet d'obtenir une multiplication prépondérante pour un seul type de porteurs, qui est avantageusement les électrons. Ainsi, si dans les modes de réalisation décrits par la suite les différentes zones semiconductrices sont réalisées dans des tellurures de mercure-cadmium, l'homme du métier peut aisément, sur la base du présent enseignement, fournir des structures selon l'invention dont les zones semiconductrice seraient réalisées par exemple dans des arséniures-antimoniures d'indium du type InAs₁₋ₓSbₓ.

On peut noter que la terminologie de « arséniure-antimoniure d'indium» utilisée ci-dessus et dans le reste de ce document doit être entendue comme correspondant aux composés comprenant l'indium et au moins un élément choisi parmi l'arsenic et l'antimoine tel' que les composés respectant la formulation suivante InAs₁₋ₓ Sbₓ avec la valeur x correspondant à la proportion d'antimoine par rapport à l'arsenic et est donc compris entre 1 et 0, 1 et 0 inclus.

On notera également que si la structure 1 présente des zones semiconductrices réalisées dans un seul type de matériaux tels que les tellurures de mercure cadmium et les arséniures-antimoniures d'indium, il est également envisageable qu'une structure selon l'invention présente des zones semiconductrices réalisées dans plusieurs type de matériaux et ceci notamment par la présence d'un substrat dans un matériau d'un autre type. Ainsi par exemple, une structure présentant ses zones « fonctionnelles » réalisées dans des tellurures de mercure-cadmium peut comporter un support réalisé en tellurure zinc-cadmium CdZnTe.

Par commodité et dans le but de simplification, le premier type de conductivité pour lequel les porteurs majoritaires sont des trous est dénommé dans le reste de ce document, en conformité avec l'entendement de l'homme de métier, dopage P. De la même manière, le deuxième type de conductivité pour lequel les porteurs majoritaires sont des trous est dénommé dans le reste de ce document dopage N.

Pour finir, les modes de réalisation décrits ci-dessous visent particulièrement la détection et à la mesure de rayonnements électromagnétiques dont la longueur d'onde est comprise dans la gamme de longueurs d'ondes du proche infrarouge. Ainsi les valeurs et les matériaux qui sont cités ci-dessus concernent particulièrement la détection et à la mesure de rayonnements électromagnétiques dont la longueur d'onde est comprise dans la gamme de longueurs d'ondes du proche infrarouge. Bien entendu, les valeurs et les matériaux concernant cette application ne sont donnés qu'à titre d'illustration et ne sont pas limitatifs. L'homme du métier est en effet à même, sur la base du présent enseignement, d'adapter les valeurs et/ou matériaux décrits pour des applications à d'autres gammes de longueurs d'onde.

On entend ci-dessus et dans le reste de ce document par gamme de longueurs d'ondes du proche infrarouge une gamme de longueurs d'ondes comprise entre 1,5 µm et 5 µm.

La structure 1 illustrée sur la figure 1 comporte :
- une première zone semiconductrice 10, dite d'absorption, dopée P présentant une première face destinée à recevoir le rayonnement électromagnétique λ et une seconde face opposée à la première face, le matériau semiconducteur dans lequel est formée ladite première zone semiconductrice 10 présentant une largeur de bande interdite adaptée pour favoriser l'absorption du rayonnement électromagnétique,
- une deuxième zone semiconductrice 20, dite de multiplication, en contact avec la seconde face de la première zone semiconductrice 10, la deuxième zone semiconductrice 10 étant dopée N et présentant une concentration en porteurs majoritaires inférieure à celle de la première zone semiconductrice 10, ladite deuxième zone semiconductrice 20 étant adaptée pour fournir une multiplication de porteurs par ionisation par impact qui est prépondérante pour les électrons,
- une cinquième zone semiconductrice 50, dite de charge, en contact avec la deuxième zone semiconductrice 20 à l'opposé de la première zone semiconductrice 10, la cinquième zone étant dopée N et présentant une concentration en porteurs majoritaires supérieure à celle de la deuxième zone semiconductrice 20,
- une troisième zone semiconductrice 30, dite d'accélération, en contact avec la cinquième zone semiconductrice 50 à l'opposé de la deuxième zone semiconductrice 20, ladite troisième zone semiconductrice 30 étant dopée N et présentant une concentration en porteurs majoritaires inférieure à celle des première et cinquième zone semiconductrice 10, 50 et similaire à celle de la deuxième zone semiconductrice 20,
- une quatrième zone semiconductrice 40, dite de collecte, en contact avec la troisième zone semiconductrice 30, ladite quatrième zone semiconductrice 40 étant d'un deuxième type de conductivité opposé au premier type de conductivité et présentant une concentration en porteurs majoritaires supérieure à celle de la deuxième zone semiconductrice 20.

Si dans ce premier mode de réalisation la deuxième et la troisième zone semiconductrice 20, 30 sont du même type de conductivité, il est également envisageable que la deuxième et la troisième zone semiconductrice 20, 30 présentent des types de conductivité opposé. Ainsi, selon cette variante de ce premier mode de réalisation, la deuxième zone semiconductrice 20 présente un dopage de type P tandis que la troisième zone semiconductrice 30 présente un dopage de type N. Bien entendu, il est également envisageable en variante, sans que l'on sorte du cadre de l'invention, que la deuxième zone semiconductrice 20 présente un dopage de type N et la troisième zone semiconductrice un dopage P, voire que la deuxième et la troisième zones semiconductrice 20, 30 présentent toutes deux un dopage P.

Avec une telle configuration de la troisième zone semiconductrice, celle-ci étant disposée entre la cinquième zone semiconductrice et la quatrième zone semiconductrice et présentant une concentration en porteurs majoritaires faible vis-à-vis des première et quatrième zone semiconductrice 10, 40, la troisième zone semiconductrice 30 est configurée pour présenter en fonctionnement de la structure 1 un champ électrique apte à fournir une dérive rapide des électrons entre la deuxième et la quatrième zone semiconductrice 20, 40. Dans une telle configuration, la troisième zone semiconductrice 30 présente également une configuration adaptée par une concentration en porteurs majoritaires et un dimensionnement adéquats pour que cette dernière troisième zone semiconductrice 30 soit exempte de multiplication de porteurs par ionisation par impact en fonctionnement de la structure 1

Ainsi, comme illustré sur la figure 1, la première zone semiconductrice 10 se présente sous la forme d'une couche semiconductrice formée dans un tellurure de mercure-cadmium du type CdₓHg₁₋ₓTe avec la valeur x correspondant à la proportion de cadmium par rapport au mercure, la proportion de cadmium étant adaptée pour correspondre à la gamme de longueurs d'onde et ainsi assurer une absorption du rayonnement électromagnétique.

Par exemple, pour des gammes de longueurs d'onde correspondant respectivement aux longueurs d'onde inférieures à 3,7 µm et à 1,8 µm, la proportion en cadmium x peut être respectivement choisie inférieure ou égale à 0,33 et à 0,55 pour un fonctionnement à une température de 300K.

Selon la possibilité illustrée sur la figure 1, comme le montre la variation de bande interdite 82 figurée sur la droite sous la référence Eg, la largeur de bande interdite peut être diminuée en direction de la deuxième zone semiconductrice, celle-ci étant néanmoins suffisante pour autoriser l'absorption du rayonnement électromagnétique λ dans la gamme de longueurs d'onde même lorsque la largeur de bande interdite est maximale. Ainsi, selon cette possibilité et les exemples donnés dans le paragraphe précédent, la proportion de cadmium reste sur toute l'épaisseur de la première zone semiconductrice 1 inférieure ou égale à 0,33 et à 0,55 pour des gammes de longueurs d'onde correspondant respectivement aux longueurs d'onde inférieures à 3,7 µm et à 1,8 µm.

La concentration en porteurs majoritaires dans la première zone semiconductrice 10 est préférentiellement comprise entre 10¹⁶ et 10¹⁷ cm⁻³. Une telle concentration en porteurs majoritaires peut être fournie par des éléments dopants, tels que l'arsenic As, l'or Au ou encore l'antimoine Sb, adaptés pour donner chacun au moins un trou lorsqu'ils sont activés. L'épaisseur de la couche formant la première zone semiconductrice dans une direction sensiblement transversale à la jonction semiconductrice est comprise entre 0,5 et 2 µm.

On peut noter qu'en variante de la possibilité de variation de largeur de bande interdite dans la première zone semiconductrice 10, il est également envisageable dans le cadre de l'invention et selon une possibilité non illustrée, que ce soit la concentration en porteurs majoritaires qui soit variée le long de l'épaisseur de la première zone semiconductrice 10. Bien entendu, selon une autre possibilité de l'invention non illustrée, la première zone semiconductrice peut comporter à la fois une variation de la concentration en cadmium et en porteurs majoritaires sur son épaisseur. De telles possibilités sont particulièrement avantageuses pour permettre un transfert accéléré de l'électron de chacune des paires électron-trou générées lors de l'absorption des photons du rayonnement électromagnétique λ par la première zone semiconductrice 10.

La première zone semiconductrice 10 présente une première et une seconde face, la première face étant destinée à recevoir le rayonnement électromagnétique λ.

La deuxième zone semiconductrice 20 se présente sous la forme d'une couche semiconductrice présentant une première et une seconde face. La deuxième zone semiconductrice 20 comporte sa première face en contact avec la seconde face de la première zone semiconductrice 10.

La deuxième zone semiconductrice 20 est dopée N est présente une concentration en porteurs majoritaires inférieure à celle de la première zone semiconductrice 10. Cette deuxième zone semiconductrice 20 est adaptée pour fournir en fonctionnement de la structure une multiplication de porteurs par ionisation par impact qui est prépondérante, voire unique, pour les électrons. Une telle multiplication sélective des seuls électrons est une propriété intrinsèque des tellurures de mercure-cadmium du type CdₓHg₁₋ₓTe avec la valeur x correspondant à la proportion de cadmium par rapport au mercure. Les arséniures-antimoniures d'indium du type InAs₁₋ₓSbₓ. présentent également une telle propriété intrinsèque de multiplication sélective des seuls électrons.

On peut noter que selon une variante de l'invention, il est également possible de fournir une telle sélectivité de la multiplication par ionisation par impact par une succession de zones semiconductrices adaptées de matériaux ne présentant pas une telle propriété intrinsèque. L'invention n'ayant pas pour objet l'obtention d'une multiplication par impact sélective pour les électrons, cette possibilité, connue de l'homme du métier, cette variante couverte par l'invention n'est pas décrite plus en détail dans ce document.

La concentration en porteurs majoritaires et l'épaisseur de la couche formant la deuxième zone semiconductrice 20 sont préférentiellement optimisées pour obtenir un gain de multiplication de porteurs maximal et un temps de parcours des électrons dans la deuxième zone minimal tout en présentant un courant tunnel contenu.

Pour obtenir une telle adaptation, la deuxième zone semiconductrice 20 comporte une concentration en porteurs majoritaires qui est préférentiellement 10 fois inférieure à celle de la première zone semiconductrice et très avantageusement 50 fois inférieure. Ainsi la deuxième zone semiconductirce peut présenter une concentration en porteurs majoritaires inférieure à 10¹⁵ cm⁻³, voire à 2x10¹⁴ cm⁻³.

La deuxième zone semiconductrice 20 peut présenter une épaisseur comprise entre 0,3 et 2 µm et préférentiellement entre 0.4 et 1 µm. Comme illustré par variation de bande interdite 82 figurée sur la droite de la figure 1 sous la référence Eg, la largeur de bande interdite est préférentiellement choisie pour être en continuité avec celle de la première zone semiconductrice 10 au niveau de sa seconde face. Les proportions de cadmium au niveau de l'interface entre la première et la deuxième zone semiconductrice 10, 20 sont donc identiques entre ces deux mêmes zones 10, 20.

La cinquième zone semiconductrice 50 se présente sous la forme d'une couche semiconductrice comprenant une première et une seconde face. La cinquième zone semiconductrice 50 comporte sa première face en contact avec la seconde face de la deuxième zone semiconductrice 20.

La cinquième zone semiconductrice 50 est dopée N et présente une concentration en porteurs majoritaires supérieure à celle de la deuxième zone semiconductrice 20. La concentration en porteurs majoritaires de la cinquième zone 50 est préférentiellement supérieure d'un facteur 10, et préférentiellement d'un facteur 100, à la concentration en porteurs majoritaires de la deuxième zone semiconductrice20. Néanmoins, il est préférable pour éviter toute perturbation du fonctionnement de la structure 1 que la concentration en porteurs majoritaires de la cinquième zone semiconductrice 50 est telle que la cinquième zone semiconductrice soit déplétée en fonctionnement de la structure 1. Une telle concentration en porteurs majoritaires peut être fournie par des éléments dopants, tels que l'aluminium Al, l'indium In ou encore le gallium, adaptés pour donner chacun au moins un électron lorsqu'ils sont activés. L'épaisseur et le niveau du dopage de la cinquième zone semiconductrice 50 est adaptée pour fournir un champ électrique, comme illustré sur la figure 1 sous la référence 81, dans la zone semiconductrice 30 maximisant la vitesse de dérive des électrons dans la zone 30 sans induire une multiplication dans cette zone. L'épaisseur de cette zone semiconductrice 50 présente une épaisseur préférentiellement faible, c'est-à-dire inférieure à 0,5 µm, afin de minimiser sa contribution au temps de réponse. L'épaisseur de la zone semiconductrice 50 est typiquement inférieure à 0.2 µm, voire inférieure à 0.1 µm.

Comme illustré par la variation de bande interdite 82 figurée sur la droite de la figure 1 sous la référence Eg, la largeur de bande interdite est préférentiellement choisie pour être en continuité avec celle de la deuxième zone semiconductrice 20. Ainsi les proportions de cadmium dans la deuxième et la cinquième zone semiconductrice 20, 50 sont donc identiques dans ce premier mode de réalisation.

La troisième zone semiconductrice 30 se présente sous la forme d'une couche semiconductrice comportant une première et une seconde face. La troisième zone semiconductrice 30 comporte sa première face en contact avec la seconde face de la cinquième zone semiconductrice 50.

La troisième zone semiconductrice est dopée N. Elle présente une concentration en porteurs majoritaires inférieure à celle de la première, quatrième et cinquième zone semiconductrice 10, 40, 50 et qui est du même ordre de grandeur que celle de la deuxième zone semiconductrice 20. Ainsi la concentration en porteurs majoritaires de la troisième zone semiconductrice peut être inférieure à 10¹⁵ cm⁻³, voire à 2x10¹⁴ cm⁻³.

Selon une possibilité avantageuse de l'invention, la concentration en porteurs majoritaires dans la troisième zone semiconductrice 30 est plus faible que celle de la deuxième zone semiconductrice 20. Ainsi, idéalement, la troisième zone présente une concentration en porteurs majoritaires du type non intentionnellement dopé, ou d'un même ordre de grandeur qu'un dopage du type non intentionnellement dopé. Une telle possibilité permet d'optimiser l'accélération des électrons entre la deuxième et la quatrième zone semiconductrice 20, 40 sans multiplication par ionisation par impact.

La troisième zone semiconductrice 30 présente une épaisseur préférentiellement supérieure à celle de la deuxième zone semiconductrice 20. Plus précisément l'épaisseur de la troisième zone semiconductrice peut préférentiellement être choisie comme étant supérieure d'un facteur 2 à celle de la deuxième zone semiconductrice 20, voire supérieure d'un facteur 3 à celle de cette même deuxième zone semiconductrice 20.

Ainsi la troisième zone semiconductrice 30 peut présenter une épaisseur comprise entre 0,6 et 6 µm et préférentiellement entre 0,8 et 3 µm. Comme illustré par la variation de bande interdite 82 figurée sur la droite de la figure 1 sous la référence Eg, la largeur de bande interdite est préférentiellement choisie pour être identique à celle de la cinquième zone semiconductrice 50. Les proportions de cadmium de la cinquième et de la troisième zone semiconductrice 50, 30 sont donc identiques.

La quatrième zone semiconductrice 40 se présente sous la forme d'une couche semiconductrice comportant une première et une seconde face. La quatrième zone semiconductrice 40 comporte sa première face en contact avec la seconde face de la troisième zone semiconductrice 30.

La quatrième zone semiconductrice 40 est dopée N. La quatrième zone semiconductrice 40 comporte une concentration en porteurs majoritaires supérieure à 10¹⁶ cm⁻³ qui peut être du même ordre de grandeur que, voire supérieure à, celle de la première couche semiconductrice 10. Ainsi la quatrième zone semiconductrice peut comprendre une concentration en porteurs majoritaires comprise entre 10¹⁶ et 10¹⁸ cm⁻³. L'épaisseur est typiquement supérieure à 0,5 µm, voire supérieure à 1 µm.

Cette structure permet, sous une polarisation inverse dans une configuration d'avalanche, de créer un champ électrique afin d'accélérer les électrons entre la couche de multiplication, c'est-à-dire la deuxième zone semiconductrice 20, et la couche de collecte, c'est-à-dire la quatrième zone semiconductrice 40, de manière à optimiser la contribution des électrons par rapport à celle des trous.

Afin d'illustrer les avantages d'une telle structure, les figures 2A et 2B permettent de mettre en parallèle les temps de réponse électronique attendus pour une structure de l'art antérieur optimisée et pour une structure selon le premier mode de réalisation de l'invention. Les courbes de réponse ainsi présentées sur les figures 2A et 2B ont été obtenues selon la méthode « modèle de réponse impulsionnelle » décrite dans l'article de G. PERRAIS et al. publié dans le journal scientifique « Journal of Electronic Materials » Volume 38 n°8 page 1790 à 1799.

Pour rendre ces structures comparables, la structure de l'art antérieur et la structure selon le premier mode l'invention dont les temps de réponse sont illustrés sur les figures 2A et 2B présentent des zones d'absorption, de multiplication et de collection aux configurations identiques.

La figure 2A illustre graphiquement la courbe 201 de réponse électronique d'une structure de type avalanche comprenant les deux couches supplémentaires pour accélérer l'injection des porteurs générés lors de l'absorption décrites par Ning Duan et ses co-auteurs. On peut voir sur cette figure 2A que le courant transmis présente deux composantes 211 et 212, une première composante 211 correspond à la contribution des électrons après l'absorption du rayonnement électromagnétique λ dans la zone d'absorption, leur multiplication dans la zone de multiplication et leur collecte, et une deuxième composante 212 correspondant à celle des trous générés dans la couche multiplication lors du passage des électrons. On peut ainsi voir dans cette structure de l'art antérieur optimisée que, si les électrons permettent d'obtenir un signal rapide avec une vitesse de transit moyenne des électrons dans la couche de multiplication de 3.10⁶ cm.s⁻¹ qui est compatible avec les applications hyperfréquences, leur contribution intégrés dans le temps est négligeable vis-à-vis de celle correspondant aux trous. Or la vitesse de transit moyenne des trous est de seulement 1.10⁶ cm.s⁻¹ et la réponse est perçue sur une durée de 60-65 ps en se prolongeant jusqu'à 80 ps. Ainsi, une telle structure selon l'art antérieur ne laisse présager qu'une bande passante atteignant les 9 GHz.

La structure selon le premier mode de réalisation de l'invention dont le temps de réponse est illustré sur la figure 2B, de manière à fournir des résultats comparables à ceux illustrés sur la figure 2A, a été choisie avec une troisième zone semiconductrice 30 présentant des dimensions identiques à celle de la couche d'accélération de la structure de l'art antérieur. La troisième zone semiconductrice 30 est 2 fois et demie plus épaisse que la zone de multiplication (1,5 µm), présente un dopage de un dopage de 10¹⁷cm⁻³ et une vitesse de dérive est estimée à 1x10⁷ cm/s. Une vitesse de dérive supérieure dans cette zone est justifiée par l'absence de multiplication qui tend à la réduire. On peut voir sur la figure 2B, que pour une structure selon l'invention, le courant transmis présente également deux composantes 211 et 212, la première correspondant à la contribution des électrons et la deuxième à celle des trous. Néanmoins, avec une structure selon l'invention, la composante 211 correspondant aux électrons, lorsqu'elle est intégrée dans le temps, est prépondérante par rapport à la composante 212 correspondant aux trous. En effet, le passage rapide des électrons dans la troisième zone semiconductrice 30 permet d'initier une évacuation de charge dans cette dernière qui augmente significativement la contribution des électrons. Ainsi, la composante des électrons 211 étant significativement plus importante que celle des trous, le circuit de lecture associé à la structure sera influencé principalement par la contribution des électrons et le signal est perçu, comme le montre la figure 2B, sur une durée inférieure à 20 ps, avec une réponse qui se prolonge donc jusqu'à 40 ps. Ainsi, une telle structure selon l'invention laisse présager d'une bande passante pouvant atteindre 20 GHz.

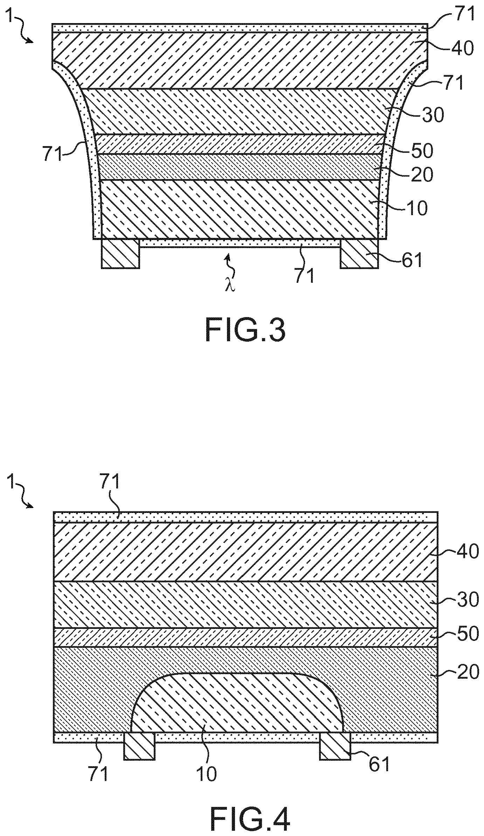

La figure 3 illustre un premier exemple pratique d'une structure 1 selon l'invention dans une configuration du type mesa. Une telle structure comporte donc, en plus des zones semiconductrices 10, 20, 30, 40, 50 :
- une délimitation du type mesa, la structure 1 ayant été gravée pour délimiter sa région active,
- une première métallisation 61, une deuxième métallisation déportée n'étant pas représentée sur la sur figure 3, afin d'appliquer les tensions de fonctionnement de la structure 1 et en récupérer le signal, la première et la deuxième métallisation 61 étant disposée en contact de la première face de la première zone semiconductrice 10, la deuxième métallisation étant en contact ohmique avec la quatrième zone semiconductrice 40 au moyen, par exemple d'un via,
- une couche de passivation 71, disposée sur la première face de la première zone semiconductrice 10 et la deuxième face de la quatrième zone semiconductrice 40 de manière à protéger les portions de surface non revêtues par la première et la deuxième métallisation 61, une partie de la couche de passivation permet également de protéger les flancs de gravure libérés lors de la gravure de la structure 1 pour former la mesa.

Bien entendu, selon une variante non illustrée, la première zone semiconductrice 10 peut être supportée par un substrat présent à l'opposé de la deuxième zone semiconductrice 20. Selon cette variante, la première face de la première zone semiconductrice 10 est en contact avec le substrat et ne nécessite donc pas de couche de passivation 71.

La première métallisation 61 et la deuxième métallisation déportée sont toutes deux réalisées dans un matériau conducteur préférentiellement métallique, adapté pour former un contact ohmique avec respectivement la première et la quatrième zone semiconductrice 10, 40.

Concernant la première métallisation 61, cette dernière est préférentiellement configurée pour occuper une surface minimale sur la première face de la première zone semiconductrice 10 ceci de manière à permettre une pénétration optimisée du rayonnement électromagnétique λ dans la première zone semiconductrice 10. Ainsi, pour l'exemple pratique illustré sur la figure 3, la première métallisation est disposée sur la périphérie de la première face de la première zone semiconductrice 10. Selon une autre possibilité de l'invention, la première métallisation peut être réalisée au moins partiellement dans un matériau conducteur, tel que l'oxyde d'indium-étain, ou ITO, qui est transparent au rayonnement électromagnétique λ. Selon cette possibilité, la première métallisation 61 peut recouvrir une majeure partie de la surface de la première face de la première zone semiconductrice 10.

Concernant la deuxième métallisation, celle-ci peut être aménagée sur la première face et mise en contact ohmique avec la quatrième zone semiconductrice par le moyen d'un via métallique aménagé dans une percée.

Les surfaces des zones semiconductrices libres de métallisation sont passivées par la couche de passivation 71 ceci afin de les protéger des dégradations chimiques, mécaniques et/ou électriques. Une telle couche de passivation 71 est préférentiellement formée dans un matériau isolant, tel que par exemple l'oxyde de silicium.

Une telle structure 1 selon ce premier exemple pratique selon l'invention peut être formée au moyen d'un procédé de fabrication comportant les étapes suivante de :
- fourniture de la première zone semiconductrice 10 dopée P et présentant une première face destinée à recevoir le rayonnement électromagnétique λ et une seconde face opposée à la première face, le matériau semiconducteur dans lequel est formée ladite première zone semiconductrice 10 présentant une largeur de bande interdite adaptée pour favoriser l'absorption du rayonnement électromagnétique λ,
- formation de la deuxième zone semiconductrice 20 en contact avec la seconde face de la première zone semiconductrice 10, la deuxième zone semiconductrice 20 étant dopée N et présentant une concentration en porteurs majoritaires inférieure à celle de la première zone semiconductrice 10, ladite deuxième zone semiconductrice 20 étant adaptée pour fournir une multiplication de porteurs par ionisation par impact qui est prépondérante pour les électrons,
- formation de la cinquième zone semiconductrice 50 en contact avec la deuxième zone semiconductrice 20 sur une face de cette dernière qui est opposée à la première zone 10 semiconductrice 10, la cinquième zone semiconductrice étant dopée N et présentant une concentration en porteurs majoritaires supérieure à celle de la deuxième zone semiconductrice 20 et qui est adaptée pour être déplétée en fonctionnement de la structure,
- formation de la troisième zone semiconductrice 30 en contact avec la cinquième zone semiconductrice 50 sur une face de cette dernière qui est opposée à la deuxième zone semiconductrice 20, la troisième zone semiconductrice 30 étant dopée N et présentant une concentration en porteurs majoritaires inférieure à celle de la première zone et de la cinquième zone semiconductrice 10, 50, ladite troisième zone semiconductrice 30 étant configurée pour présenter en fonctionnement un champ électrique apte à fournir une accélération des électrons entre la deuxième et la quatrième zone semiconductrice 20, 40 sans multiplication de porteurs par ionisation par impact,
- formation de la quatrième zone semiconductrice 40 en contact avec la troisième zone semiconductrice 30 sur une face de cette dernière qui est opposée à la cinquième zone semiconductrice 50, ladite quatrième zone semiconductrice 40 étant dopée N et présentant une concentration en porteurs majoritaires supérieure à celle des deuxième et troisième zone semiconductrice 20, 30,
- gravure partielle de la quatrième, troisième, cinquième, deuxième zone 40, 30, 50, 20 de manière à atteindre la première zone semiconductrice 10 et pour former une mesa,
- formation de la première et la deuxième métallisation 61 en contact ohmique de la première et de la quatrième zone semiconductrice,
- passivation des surfaces de la première et de la quatrième zone semiconductrice 10, 40 libres de métallisation 61 et sur les flancs de la mesa au moyen d'une couche de passivation 71.

Les étapes de fourniture et de formation d'une zone, telles que la fourniture de la première zone semiconductrice 10 ou la formation de la deuxième zone semiconductrice 20, peuvent être réalisées par un dépôt par épitaxie tel qu'une épitaxie par jet moléculaire ou une épitaxie en phase vapeur. Avec de telles méthodes, il est possible de former les différentes zones semiconductrices en faisant varier pendant l'étape de dépôt, dans le cas où la structure est formée de tellurures de mercure-cadmium, la proportion en cadmium par rapport au mercure, le type des éléments dopants ainsi que leur concentration. Bien entendu, une étape de formation d'une zone semiconductrice donnée permet de fournir ladite zone semiconductrice et correspond donc également à une étape de fourniture de cette même zone semiconductrice.

Bien entendu, l'ordre des étapes du procédé de fabrication décrit ci-dessus n'est donné qu'à titre d'exemple et il est également possible que certaines étapes soient réalisées préalablement ou postérieurement à l'ordre fourni.

On notera ainsi par exemple qu'il est parfaitement possible dans le cadre d'un tel procédé de fabrication de prévoir une première étape de fourniture de la quatrième zone semiconductrice 40. Dans un procédé selon cette possibilité, l'étape de fourniture de la quatrième zone semiconductrice 40 sera suivie par les étapes de formation de la troisième zone semiconductrice 30, de formation de la cinquième zone semiconductrice 50, de formation de la deuxième zone semiconductrice 20 et de formation de la première zone semiconductrice 10. De la même façon, l'étape de gravure peut alors consister à effectuer une gravure partielle de la première, deuxième, la cinquième et la cinquième zone semiconductrice 10, 20, 50, 30 de manière à atteindre la quatrième zone semiconductrice et pour former la mesa.

La figure 4 illustre un deuxième exemple pratique d'une structure 1 selon le premier mode de réalisation de l'invention dans lequel la structure 1 présente une configuration dite planaire, la zone active d'une telle structure 1 étant délimitée par la forme de la première zone semiconductrice 10.

La structure 1 selon ce deuxième exemple pratique se différencie d'une structure 1 selon le premier mode de réalisation de l'invention illustrée sur la figure 1 et le premier exemple pratique de l'invention, en ce que la première zone semiconductrice 10 ne prend pas la forme d'une couche semiconductrice mais la forme d'une zone surdopée inscrite dans une couche semiconductrice dans laquelle est formée la deuxième zone semiconductrice 20.

Ainsi selon ce deuxième exemple pratique du premier mode de réalisation, la deuxième zone semiconductrice 20 et la première zone semiconductrice 10, se présente sous la forme d'une seule couche semiconductrice dans laquelle une première portion forme la première zone semiconductrice 10 et le reste de la couche forme la deuxième zone semiconductrice 20. La couche semiconductrice formant la première et la deuxième zone semiconductrice 20 présente une première et une deuxième face, la deuxième face correspondant à celle par laquelle la deuxième zone semiconductrice 20 est en contact avec la cinquième zone semiconductrice 50. La première portion formant la première zone semiconductrice 10 s'étend à partir de la première face de la couche semiconductrice de telle manière qu'une partie de la première face de la couche formant la deuxième zone semiconductrice 20 forme la première face de la première zone semiconductrice 10 qui est destinée à recevoir le rayonnement électromagnétique.

Selon une variante non illustrée et un principe similaire à ce deuxième exemple pratique, la troisième zone semiconductrice 30 et la quatrième zone semiconductrice 40, peuvent se présenter sous la forme d'une seule couche semiconductrice dans laquelle une première portion forme la quatrième zone semiconductrice 40 et le reste de la couche forme la troisième zone semiconductrice 30.

S'agissant du dimensionnement d'une telle structure, on notera qu'avec la configuration de la première et la deuxième zone semiconductrice 10, 20 selon ce deuxième exemple pratique, les épaisseurs de la première et de la deuxième zone semiconductrice correspondent respectivement à l'épaisseur moyenne de la première portion et l'épaisseur de la couche semiconductrice à laquelle on retranche l'épaisseur moyenne de la première portion.

Un procédé de fabrication selon ce deuxième exemple pratique se différencie d'une procédé de fabrication selon le premier exemple pratique en ce qu'il :
- comporte à la place des étapes de fourniture de la deuxième zone semiconductrice 20 et de formation de la première zone semiconductrice 10, une étape de fourniture d'une couche semiconductrice dopée P destinée à fournir la première et la deuxième zone semiconductrice 10, 20, la couche semiconductrice présentant la concentration en porteurs majoritaires de la deuxième zone semiconductrice 20, et une étape d'implantation d'éléments dopants du type P pour former la première zone semiconductrice 10,
- ne comporte pas nécessairement d'étape de gravure d'une mesa interceptant la zone 10, et
- l'étape de passivation consiste à passiver les surface exempte de métallisation de la première face de la couche semiconductrice formant la première et la deuxième zone semiconductrice 10, 20 et optionnellement de la deuxième face de la quatrième zone semiconductrice 40.

Bien entendu, de la même façon que pour le procédé de fabrication d'une structure selon le premier exemple pratique décrit précédemment, l'ordre des étapes n'est donné qu'à titre d'exemple et il est également possible que certaines étapes soient réalisées préalablement ou postérieurement à l'ordre fourni.

Il est donc ainsi également envisageable que dans le cadre d'un tel procédé de fabrication débute par une première étape de fourniture de la quatrième zone semiconductrice 40. Ainsi, l'étape de fourniture de la quatrième zone semiconductrice 40 peut alors être suivie par les étapes de formation de la troisième zone semiconductrice 30, de formation de la cinquième zone semiconductrice 50, de formation de la couche semiconductrice destinée à former la deuxième zone semiconductrice 20, et d'implantation de la couche semiconductrice pour former la première zone semiconductrice 10 et la deuxième zone semiconductrice 20.

Selon une variante non illustrée, la quatrième zone semiconductrice 40 peut être supportée par un substrat présent à l'opposé de la troisième zone semiconductrice 30. Selon cette variante, la deuxième face de la quatrième zone semiconductrice 40 est en contact avec le substrat et ne nécessite donc pas de couche de passivation 71.

De la même façon, il également envisageable, en variante non illustrée, de prévoir à distance, une délimitation de la troisième zone semiconductrice 30 par exemple en gravant une mesa.

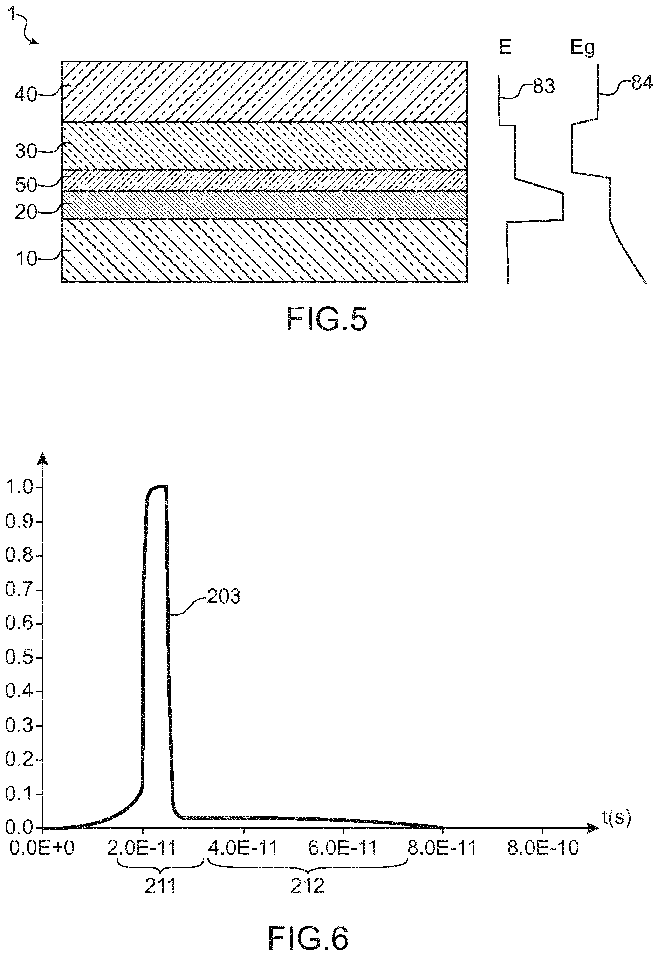

La figure 5 illustre une structure selon un deuxième mode de réalisation de l'invention dans laquelle la troisième zone présente une largeur de bande interdite de faible énergie. Une telle structure se différencie, comme le montre la variation de bande interdite 84 figurée sur la droite de la figure 5 sous la référence Eg, uniquement par la largeur de bande interdite de la troisième zone semiconductrice 30.

Dans ce deuxième mode de réalisation, la troisième zone semiconductrice 30 présente une largeur de bande interdite inférieure à celle des autres zones semiconductrices 10, 20, 40 ,50 ceci de manière à présenter une vitesse de saturation des électrons qui est fortement améliorée. En effet, pour une largeur de bande interdite passant de 0.4 à 0.25 eV, la vitesse de saturation des électrons dans la couche d'accélération passe de 1.10⁷ cm.s⁻¹ à 3.10⁷ cm.s⁻¹. L'effet du champ électrique 83 généré par la cinquième zone semiconductrice 50 dans la troisième zone semiconductrice 30 s'en trouve ainsi optimisé.

La figure 6 permet d'illustrer, selon une méthode identique à celle utilisé pour les figures 2A et 2B, le temps de réponse électronique attendu d'une structure selon ce deuxième mode de réalisation. La configuration de la structure dont le temps de réponse est illustré sur la figure 6 est identique à celle de la structure dont le temps de réponse est illustré sur la figure 2B à la seule différence que la bande interdite de la troisième zone semiconductrice est réduite, celle-ci présentant une proportion de cadmium x égale à 0,3 (Eg∼0,25 eV).

On peut voir sur la figure 6 que le temps de réponse de la structure est significativement amélioré. En effet, de même que pour le temps de réponse illustré sur la figure 2B, la contribution électronique 211 est majoritaire vis-à-vis de celle des trous et est perçu sur une durée de 6 ps, la réponse se prolongeant jusqu'à 26 ps. Ainsi, une telle structure selon ce deuxième mode de réalisation de l'invention laisse présager d'une bande passante pouvant atteindre 70 GHz.

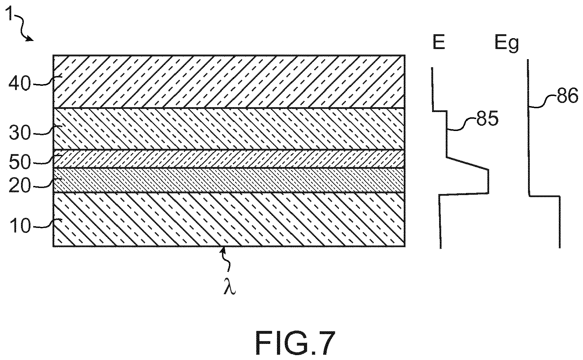

La figure 7 illustre une structure 1 selon un troisième mode de réalisation de l'invention dans lequel la deuxième zone semiconductrice 20 forme à la fois une zone d'absorption et une zone de multiplication. Ainsi une telle structure 1 se différencie d'une structure 1 selon le premier mode de réalisation en ce que la première zone semiconductrice 10 est réalisée dans un matériau semiconducteur transparent au rayonnement électromagnétique λ et en ce que la deuxième zone semiconductrice 20 est formée dans un matériau semiconducteur présentant une largeur de bande interdite adaptée pour favoriser l'absorption du rayonnement électromagnétique λ.

Dans un tel mode de réalisation et comme illustré sur la figure 7, la première zone semiconductrice 10 se présente sous la forme d'une couche semiconductrice formée dans un tellurure de mercure-cadmium du type CdₓHg₁₋ₓTe avec la valeur x correspondant à la proportion de cadmium par rapport au mercure, la proportion de cadmium étant adaptée pour correspondre à la gamme de longueurs d'onde et ainsi assurer une transparence au rayonnement électromagnétique.

Par exemple, pour des gammes de longueurs d'onde correspondant respectivement aux longueurs d'onde supérieures à 1.4 µm et à 1.2 µm, la proportion en cadmium x peut être respectivement choisie supérieure ou égale à 0,66 et à 0,75 pour un fonctionnement à une température de 300K.

Selon la possibilité illustrée sur la figure 7, comme le montre la bande interdite 86 figurée sur la droite sous la référence Eg, la largeur de bande interdite de la première zone semiconductrice 10 présente une valeur sensiblement constante. Ainsi, selon cette possibilité et les exemples donnés dans le cadre du premier mode de rélisation, la proportion de cadmium Est sur toute l'épaisseur de la première zone semiconductrice 10 supérieure à 0,66 et à 0,75 pour des gammes de longueurs d'onde correspondant respectivement aux longueurs d'onde supérieures à 1,4 µm et à 1,2 µm.

La deuxième zone semiconductrice 20 se présente sous la forme d'une couche semiconductrice formée dans un tellurure de mercure-cadmium du type CdₓHg₁₋ₓTe avec la valeur x correspondant à la proportion de cadmium par rapport au mercure, la proportion de cadmium étant adaptée pour correspondre à la gamme de longueurs d'onde et ainsi assurer une absorption du rayonnement électromagnétique. Pour des gammes de longueurs d'onde correspondant respectivement aux longueurs d'onde inférieures à 3,7 µm et à 1,8 µm, la proportion en cadmium x peut être respectivement choisie inférieure ou égale à 0,33 et à 0,55 pour un fonctionnement à une température de 300K.

Selon la possibilité illustrée sur la figure 7, comme le montre la variation de bande interdite 86 figurée sur la droite sous la référence Eg, la largeur de bande interdite est choisie pour autoriser l'absorption du rayonnement électromagnétique λ dans la gamme de longueurs d'onde. Ainsi, selon cette possibilité et les exemples donnés dans le paragraphe précédent, la proportion de cadmium reste sur toute l'épaisseur de la première zone semiconductrice 1 inférieure ou égale à 0,33 et à 0,55 pour des gammes de longueurs d'onde correspondant respectivement aux longueurs d'onde inférieures à 3,7 µm et à 1,8 µm.

Le procédé de fabrication d'une structure selon ce troisième mode de réalisation se différencie d'un procédé selon le premier mode de réalisation uniquement dans la composition des première et deuxième zones semiconductrices 10, 20 lors des étapes de fourniture de ces dernières.

Une structure 1 selon ce troisième mode de réalisation est particulièrement avantageuse pour des applications, telles que celles des télécommunications, dans lesquelles les fréquences de fonctionnement sont à privilégiées sur le rapport signal sur bruit de la structure. En effet, avec une telle configuration, l'absorption et la multiplication ayant lieu dans la même zone semiconductrice, le bruit du à la multiplication s'en trouve augmenté.

Bien entendu, les exemples pratiques décrits pour le premier mode de réalisation sont parfaitement compatibles avec ce deuxième et ce troisième mode de réalisation, l'étape de formation de la troisième zone semiconductrice 30 étant adaptée pour que cette dernière présente une largeur de bande interdite inférieure aux autres zones semiconductrices 10, 20, 40, 50 de la structure 1.

On notera également, que dans ce deuxième et ce troisième mode de réalisation, de manière identique au premier mode de réalisation, il est également envisageable, en variante et sans que l'on sorte du cadre de l'invention, que l'une ou les deux de la deuxième et la troisième zone semiconductrice présentent un dopage P à la place d'un dopage N.

## Revendications

1. Structure (1) du type photodiode à avalanche destinée à recevoir un rayonnement électromagnétique (λ) dans une première gamme de longueurs d'onde, la structure (1) comportant :
- une première zone semiconductrice (10), d'un premier type de conductivité pour lequel les porteurs majoritaires sont les trous, et présentant une première face destinée à recevoir le rayonnement électromagnétique (λ) et une seconde face opposée à la première face,
- une deuxième zone semiconductrice (20), dite de multiplication en contact avec la seconde face de la première zone semiconductrice (10) et présentant une concentration en porteurs majoritaires inférieure à celle de la première zone semiconductrice (10), la deuxième zone semiconductrice étant conformée pour fournir une multiplication de porteurs par ionisation par impact prépondérante pour les électrons,
- une quatrième zone semiconductrice (40), dite de collecte, la quatrième zone semiconductrice (40) étant d'un deuxième type de conductivité pour lequel les porteurs majoritaires sont les électrons, et présentant une concentration en porteurs majoritaires supérieure que celle de la deuxième zone semiconductrice (20),
au moins l'une de la première et la deuxième zone semiconductrice (10, 20) étant formée dans un matériau semiconducteur présentant une largeur de bande interdite adaptée pour favoriser l'absorption du rayonnement électromagnétique (λ),
la structure (1) étant **caractérisée en ce que** qu'elle comprend en outre une troisième et une cinquième zone semiconductrice (30, 50) agencées entre la deuxième zone semiconductrice (20) et la quatrième zone semiconductrice (40), la troisième zone semiconductrice (30) comportant une concentration en porteurs majoritaires inférieure à celle des première, quatrième et cinquième zones semiconductrices (10, 40, 50), la cinquième zone semiconductrice (50) étant du deuxième type de conductivité et comportant une concentration en porteurs majoritaires supérieure à celle de la deuxième zone semiconductrice (20) de telle manière à créer dans la troisième zone semiconductrice (30) un champ électrique sans multiplication de porteurs par ionisation par impact.

2. Structure (1) selon la revendication 1, dans laquelle la deuxième zone semiconductrice (20) est formée dans le matériau semiconducteur qui présente une largeur de bande interdite adaptée pour favoriser l'absorption du rayonnement électromagnétique (λ).

3. Structure (1) selon la revendication 1, dans laquelle la première zone semiconductrice (10) est formée dans le matériau semiconducteur qui présente une largeur de bande interdite adaptée pour favoriser l'absorption du rayonnement électromagnétique (λ).

4. Structure (1) selon l'une quelconque des revendications 1 à 3, dans laquelle la cinquième zone semiconductrice (50) comporte une concentration en porteurs majoritaires adaptée pour que la cinquième zone semiconductrice (50) soit déplétée en fonctionnement de la structure (1).

5. Structure (1) selon l'une quelconques des revendications 1 à 4, dans laquelle la troisième zone semiconductrice (30) est du deuxième type de conductivité.

6. Structure (1) selon l'une quelconque des revendications 1 à 5, dans laquelle la deuxième zone semiconductrice (20) est du deuxième type de conductivité.

7. Structure (1) selon l'une quelconque des revendications 1 à 6, comportant en outre une jonction semiconductrice qui s'étend selon un plan de jonction, la deuxième et la troisième zone semiconductrice (20, 30) comportant chacune une épaisseur selon une direction transversale audit plan de jonction, et
dans laquelle l'épaisseur de la troisième zone semiconductrice (30) est supérieure à celle de la deuxième zone semiconductrice (20), l'épaisseur de la troisième zone semiconductrice (30) étant préférentiellement supérieure à deux fois, voire trois fois, celle de la deuxième zone semiconductrice (20).

8. Structure (1) selon l'une quelconque des revendications 1 à 7, dans laquelle la troisième zone semiconductrice (30) comporte une largeur de bande interdite inférieure à celle du matériau semiconducteur présentant une largeur de bande interdite adaptée pour favoriser l'absorption du rayonnement électromagnétique (λ) dans lequel au moins l'une de la première et la deuxième zone semiconductrice (10, 20) est formée, la troisième zone semiconductrice (30) comportant préférentiellement une largeur de bande interdite inférieure à celle des première, deuxième, quatrième et cinquième zone semiconductrice (10, 20, 40, 50).

9. Structure (1) selon l'une quelconque des revendication 1 à 8, dans laquelle la première et la deuxième zone semiconductrice (10, 20) sont intégrées à une couche semiconductrice, la couche semiconductrice comportant une première face et une deuxième face, une première portion de la couche semiconductrice s'étendant à partir d'une partie de la première face formant la première zone semiconductrice (10), le reste de la couche semiconductrice formant la deuxième zone semiconductrice (20).

10. Structure (1) selon l'une quelconque des revendications 1 à 9, dans laquelle la troisième et la quatrième zone semiconductrice (30, 40) intégrées à une couche semiconductrice, la couche semiconductrice comportant une première portion formant la quatrième zone semiconductrice (40) et le reste de la couche semiconductrice formant la troisième zone semiconductrice (30).

11. Structure (1) selon l'une quelconque des revendications 1 à 8, dans laquelle chacune de la première à la cinquième zone semiconductrice (10, 20, 30, 40, 50) est formée par une couche semiconductrice respective, les zones semiconductrices (10, 20, 30, 40, 50) étant mises en contact les unes avec les autres par les faces des couches semiconductrices les formant.

12. Structure (1) selon la revendication 11, dans laquelle au moins une partie des couches semiconductrices formant des première à la cinquième zones semiconductrices (10, 20, 30, 40, 50) est délimitée spatialement par les parois d'une mesa.

13. Procédé de fabrication d'une structure (1) du type photodiode à avalanche, le procédé **étant caractérisé en ce qu'**il comprend les étapes suivantes de :
- fourniture d'une première zone semiconductrice (10) d'un premier type de conductivité pour lequel les porteurs majoritaires sont les électrons, et présentant une première face destinée à recevoir le rayonnement électromagnétique (λ) et une seconde face opposée à la première face
- fourniture d'une deuxième zone semiconductrice (20), dite de multiplication, la deuxième zone semiconductrice (20) présentant une concentration en porteurs majoritaires inférieure à celle de la première zone semiconductrice (10), ladite deuxième zone semiconductrice (20) étant adaptée pour fournir une multiplication de porteurs par ionisation par impact qui est prépondérante pour les électrons, les étapes de fourniture de la première et de la deuxième zone semiconductrice (10, 20) étant réalisées de manière à ce que la deuxième zone semiconductrice (20) soit en contact avec la seconde face de la première zone semiconductrice (10), au moins l'une de la première et la deuxième zone semiconductrice (10, 20) étant formée dans un matériau semiconducteur présentant une largeur de bande interdite adaptée pour favoriser l'absorption du rayonnement électromagnétique (λ),
- fourniture d'une troisième zone semiconductrice (30) et d'une cinquième zone semiconductrice (50),
- fourniture d'une quatrième zone semiconductrice (40), dite de collecte, ladite quatrième zone semiconductrice (40) étant d'un deuxième type de conductivité pour lequel les porteurs majoritaires sont les électrons, et présentant une concentration en porteurs majoritaires supérieure à celle de la deuxième zone semiconductrice (20),
dans lequel les étapes de fourniture de la troisième et de la cinquième zone semiconductrice (30, 50) étant réalisées de manière que les troisième et de la cinquième zones semiconductrices (30, 50) soient agencées entre la deuxième zone semiconductrice (20) et la quatrième zone semiconductrice (40), la troisième zone semiconductrice (30) comportant une concentration en porteurs majoritaires inférieure à celle de la zone semiconductrice d'absorption et à celles des quatrième et cinquième zones semiconductrices (40, 50) et la cinquième zone semiconductrice (50) étant du deuxième type de conductivité et comportant une concentration en porteurs majoritaires supérieure à celle de la zone semiconductrice de multiplication de telle manière à créer dans la troisième zone semiconductrice (30) un champ électrique sans multiplication de porteurs par ionisation par impact.

14. Procédé de fabrication selon la revendication 13 dans lequel l'étape de fourniture de la première zone semiconductrice (10) est préalable aux étapes de fourniture de la deuxième, de la troisième, de la quatrième et de la cinquième zone semiconductrice (20, 30, 40, 50)
et dans lequel les étapes respectives et successives de fourniture des deuxième, cinquième, troisième et quatrième zones semiconductrices (20, 50, 30, 40) consistent chacune en une étape de formation de ladite zone en contact de la zone semiconductrice formée précédemment, la deuxième zone semiconductrice (20) étant formée en contact avec la première zone semiconductrice (10).

15. Procédé de fabrication selon la revendication 13 dans lequel l'étape de fourniture de la quatrième zone est préalable aux étapes de fourniture de la première, deuxième, troisième et cinquième zone semiconductrice (20, 30, 40, 50)
et dans lequel les étapes respectives et successives de fourniture des troisième, éventuelle cinquième, deuxième et première zones semiconductrices (30, 50, 20, 10) consistent chacune en une étape de formation de ladite zone en contact de la zone semiconductrice formée précédemment, la troisième zone semiconductrice étant formée en contact avec la quatrième zone semiconductrice (40).

## Patentansprüche

1. Struktur (1) vom Typ Lawinenfotodiode, die dazu bestimmt ist, eine elektromagnetische Strahlung (λ) in einem ersten Wellenlängenbereich zu empfangen, wobei die Struktur (1) enthält:
- einen ersten Halbleiterbereich (10) von einem ersten Leitfähigkeitstyp, bei dem die Majoritätsladungsträger Löcher sind, und mit einer erste Seite, die dazu bestimmt ist, die elektromagnetische Strahlung (λ) zu empfangen, und mit einer der ersten Seite entgegengesetzten zweiten Seite,
- einen zweiten sogenannten Multiplikations-Halbleiterbereich (20) in Kontakt mit der zweiten Seite des ersten Halbleiterbereichs (10), der eine Konzentration an Majoritätsladungsträgern aufweist, die geringer als die des ersten Halbleiterbereichs (10) ist, wobei der zweite Halbleiterbereich dazu ausgebildet ist, eine Multiplikation von Ladungsträgern durch Stoßionisation bereitzustellen, die für die Elektronen überwiegt,
- einen vierten sogenannten Sammel-Halbleiterbereich (40), wobei der vierte Halbleiterbereich (40) von einem zweiten Leitfähigkeitstyp ist, bei dem die Majoritätsladungsträger Elektronen sind, und eine Konzentration an Majoritätsladungsträgern aufweist, die höher als die des zweiten Halbleiterbereichs (20) ist,
wobei zumindest einer aus erstem und zweitem Halbleiterbereich (10, 20) aus einem Halbleitermaterial gebildet ist, das einen verbotenen Bandabstand aufweist, der dazu ausgelegt ist, die Absorption der elektromagnetischen Strahlung (λ) zu begünstigen,
wobei die Struktur (1) **dadurch gekennzeichnet ist, dass** sie ferner einen dritten und einen fünften Halbleiterbereich (30, 50) aufweist, die zwischen dem zweiten Halbleiterbereich (20) und dem vierten Halbleiterbereich (40) angeordnet sind, wobei der dritte Halbleiterbereich (30) eine Konzentration an Majoritätsladungsträgern aufweist, die geringer als die des ersten, vierten und fünften Halbleiterbereichs (10, 40, 50) ist, wobei der fünfte Halbleiterbereich (50) vom zweiten Leitfähigkeitstyp ist und eine Konzentration an Majoritätsladungsträgern aufweist, die höher als die des zweiten Halbleiterbereichs (20) ist, so dass in dem dritten Halbleiterbereich (30) ein elektrisches Feld ohne Multiplikation der Ladungsträger durch Stoßionisation erzeugt wird.

2. Struktur (1) nach Anspruch 1, wobei der zweite Halbleiterbereich (20) aus dem Halbleitermaterial gebildet ist, das einen verbotenen Bandabstand aufweist, der dazu ausgelegt ist, die Absorption der elektromagnetischen Strahlung (λ) zu begünstigen.

3. Struktur (1) nach Anspruch 1, wobei der erste Halbleiterbereich (10) aus dem Halbleitermaterial gebildet ist, das einen verbotenen Bandabstand aufweist, der dazu ausgelegt ist, die Absorption der elektromagnetischen Strahlung (λ) zu begünstigen.

4. Struktur (1) nach einem der Ansprüche 1 bis 3, wobei der fünfte Halbleiterbereich (50) eine Konzentration an Majoritätsladungsträgern aufweist, die dazu ausgelegt ist, dass der fünfte Halbleiterbereich (50) bei Betrieb der Struktur (1) verarmt.

5. Struktur (1) nach einem der Ansprüche 1 bis 4, wobei der dritte Halbleiterbereich (30) vom zweiten Leitfähigkeitstyp ist.

6. Struktur (1) nach einem der Ansprüche 1 bis 5, wobei der zweite Halbleiterbereich (20) vom zweiten Leitfähigkeitstyp ist.

7. Struktur (1) nach einem der Ansprüche 1 bis 6, ferner enthaltend einen Halbleiterübergang, der sich entlang einer Übergangsebene erstreckt, wobei der zweite und der dritte Halbleiterbereich (20, 30) jeweils eine Dicke in einer Richtung quer zur Übergangsebene aufweist, und wobei die Dicke des dritten Halbleiterbereichs (30) höher als die des zweiten Halbleiterbereichs (20) ist, wobei die Dicke des dritten Halbleiterbereichs (30) vorzugsweise höher als die zwei- bzw. dreifache Dicke des zweiten Halbleiterbereichs (20) ist.

8. Struktur (1) nach einem der Ansprüche 1 bis 7, wobei der dritte Halbleiterbereich (30) einen verbotenen Bandabstand aufweist, der geringer ist als der des Halbleitermaterials, das einen verbotenen Bandabstand zum Begünstigen der Absorption von elektromagnetischer Strahlung (λ) aufweist und aus dem zumindest einer aus erstem und zweitem Halbleiterbereich (10, 20) gebildet wird, wobei der dritte Halbleiterbereich (30) vorzugsweise einen verbotenen Bandabstand aufweist, der geringer als der des ersten, zweiten, vierten und fünften Halbleiterbereichs (10, 20, 40, 50) ist.

9. Struktur (1) nach einem der Ansprüche 1 bis 8, wobei der erste und der zweite Halbleiterbereich (10, 20) einer Halbleiterschicht integriert sind, wobei die Halbleiterschicht eine erste Seite und eine zweite Seite aufweist, wobei ein erster Abschnitt der Halbleiterschicht sich ausgehend von einem Teil der ersten Seite erstreckt, der den ersten Halbleiterbereich (10) bildet, wobei die restliche Halbleiterschicht den zweiten Halbleiterbereich (20) bildet.

10. Struktur (1) nach einem der Ansprüche 1 bis 9, wobei der dritte und der vierte Halbleiterbereich (30, 40) einer Halbleiterschicht integriert sind, wobei die Halbleiterschicht einen ersten Abschnitt enthält, der den vierten Halbleiterbereich (40) bildet, wobei die restliche Halbleiterschicht den dritten Halbleiterbereich (30) bildet.

11. Struktur (1) nach einem der Ansprüche 1 bis 8, wobei jeder aus erstem bis fünftem Halbleiterbereich (10, 20, 30, 40, 50) aus einer jeweiligen Halbleiterschicht gebildet ist, wobei die Halbleiterbereiche (10, 20, 30, 40, 50) über die Seiten der Halbleiterschichten, die sie bilden, in Kontakt miteinander gebracht sind.

12. Struktur (1) nach Anspruch 11, wobei zumindest ein Teil der Halbleiterschichten, die den ersten bis fünften Halbleiterbereich (10, 20, 30, 40, 50) bilden, räumlich durch die Wände einer Mesa begrenzt ist.

13. Verfahren zum Herstellen einer Struktur (1) vom Typ Lawinenfotodiode, wobei das Verfahren **dadurch gekennzeichnet ist, dass** es die nachstehenden Schritte umfasst:
- Bereitstellen eines ersten Halbleiterbereichs (10) von einem ersten Leitfähigkeitstyp, bei dem die Majoritätsladungsträger Elektronen sind, und mit einer erste Seite, die dazu bestimmt ist, die elektromagnetische Strahlung (λ) zu empfangen, und mit einer der ersten Seite entgegengesetzten zweiten Seite,
- Bereitstellen eines zweiten sogenannten Multiplikations-Halbleiterbereichs (20), wobei der zweite Halbleiterbereich (20) eine Konzentration an Majoritätsladungsträgern aufweist, die geringer als die des ersten Halbleiterbereichs (10) ist, wobei der zweite Halbleiterbereich (20) dazu ausgebildet ist, eine Multiplikation von Ladungsträgern durch Stoßionisation bereitzustellen, die für die Elektronen überwiegt, wobei die Schritte des Bereitstellens des ersten und des zweiten Halbleiterbereichs (10, 20) so erfolgen, dass der zweite Halbleiterbereich (20) in Kontakt mit der zweiten Seite des ersten Halbleiterbereichs (10) ist, wobei zumindest einer aus erstem und zweitem Halbleiterbereich (10, 20) aus einem Halbleitermaterial gebildet ist, das einen verbotenen Bandabstand aufweist, der dazu ausgelegt ist, die Absorption der elektromagnetischen Strahlung (λ) zu begünstigen,
- Bereitstellen eines dritten Halbleiterbereichs (30) und eines fünften Halbleiterbereichs (50),
- Bereitstellen eines vierten sogenannten Sammel-Halbleiterbereichs (40), wobei der vierte Halbleiterbereich (40) von einem zweiten Leitfähigkeitstyp ist, bei dem die Majoritätsladungsträger Elektronen sind, und eine Konzentration an Majoritätsladungsträgern aufweist, die höher als die des zweiten Halbleiterbereichs (20) ist,
wobei die Schritte des Bereitstellens des dritten und des fünften Halbleiterbereichs (30, 50) so erfolgen, dass der dritte und der fünfte Halbleiterbereich (30, 50) zwischen dem zweitem Halbleiterbereich (20) und dem vierten Halbleiterbereich (40) angeordnet sind, wobei der dritte Halbleiterbereich (30) eine Konzentration an Majoritätsladungsträgern aufweist, die geringer als die des Absorptions-Halbleiterbereichs und als die des vierten und fünften Halbleiterbereichs (40, 50) ist, und wobei der fünfte Halbleiterbereich (50) vom zweiten Leitfähigkeitstyp ist und eine Konzentration an Majoritätsladungsträgern aufweist, die höher als die des zweiten Multiplikations-Halbleiterbereichs ist, so dass in dem dritten Halbleiterbereich (30) ein elektrisches Feld ohne Multiplikation der Ladungsträger durch Stoßionisation erzeugt wird.

14. Herstellungsverfahren nach Anspruch 13, wobei der Schritt des Bereitstellens des ersten Halbleiterbereichs (10) vor den Schritten des Bereitstellens des zweiten, dritten, vierten und fünften Halbleiterbereichs (20, 30, 40, 50) erfolgt,
und wobei die jeweiligen, aufeinanderfolgenden Schritte des Bereitstellens des zweiten, fünften, dritten und vierten Halbleiterbereichs (20, 50, 30, 40) jeweils aus einem Schritt des Bildens des Kontaktbereichs des zuvor gebildeten Halbleiterbereichs bestehen, wobei der zweite Halbleiterbereich (20) in Kontakt mit dem ersten Halbleiterbereich (10) gebildet wird.

15. Herstellungsverfahren nach Anspruch 13, wobei der Schritt des Bereitstellens des vierten Halbleiterbereichs vor den Schritten des Bereitstellens des ersten, zweiten, dritten und fünften Halbleiterbereichs (20, 30, 40, 50) erfolgt,
und wobei die jeweiligen, aufeinanderfolgenden Schritte des Bereitstellens des dritten, gegebenenfalls des fünften, zweiten und ersten Halbleiterbereichs (30, 50, 20, 10) jeweils aus einem Schritt des Bildens des Kontaktbereichs des zuvor gebildeten Halbleiterbereichs bestehen, wobei der dritte Halbleiterbereich in Kontakt mit dem vierten Halbleiterbereich (40) gebildet wird.

## Claims

1. Avalanche photodiode type structure (1) designed to receive an electromagnetic radiation (λ) within a first range of wave lengths, the structure (1) comprising:
- a first semiconducting zone (10) of a first type of conductivity for which the majority carriers are holes, and with a first face intended to receive the electromagnetic radiation (λ) and a second face opposite the first face,
- a second semiconducting zone (20), called the multiplication zone, in contact with the second face of the first semiconducting zone (10) and with a lower concentration of majority carriers than the first semiconducting zone (10), the second semiconducting zone being conformed to supply a multiplication of carriers by impact ionisation that is preponderant for electrons,
- a fourth semiconducting zone (40) called the collection zone, the fourth semiconducting zone (40) being of a second type of conductivity for which the majority carriers are electrons and having a higher concentration of majority carriers than the second semiconducting zone (20),
at least one of the first and second semiconducting zones (10, 20) being formed from a semiconducting material with a suitable band gap width to promote absorption of the electromagnetic radiation (λ),
the structure (1) being **characterised in that** it comprises a third and a fifth semiconducting zone (30, 50) arranged between the second semiconducting zone (20) and the fourth semiconducting zone (40), the third semiconducting zone (30) having a lower concentration of majority carriers than the first, fourth and fifth semiconducting zones (10, 40, 50), the fifth semiconducting zone (50) being of the second type of conductivity and having a higher concentration of majority carriers than the second semiconducting zone (20) so as to create an electric field in the third semiconducting zone (30) without multiplication of carriers by impact ionisation.

2. Structure (1) according to claim 1, in which the second semiconducting zone (20) is formed in the semiconducting material that has a band gap width adapted to promote absorption of the electromagnetic radiation (λ).

3. Structure (1) according to claim 1, in which the first semiconducting zone (10) is formed in the semiconducting material that has a band gap width adapted to promote absorption of the electromagnetic radiation (λ).

4. Structure (1) according to any one of claims 1 to 3, in which the fifth semiconducting zone (50) has a concentration of majority carriers adapted so that the fifth semiconducting zone (50) is depleted during operation of the structure (1).

5. Structure (1) according to any one of claims 1 to 4, in which the third semiconducting zone (30) is of the second type of conductivity.

6. Structure (1) according to any one of claims 1 to 5, in which the second semiconducting zone (20) is of the second type of conductivity.

7. Structure (1) according to any one of claims 1 to 6, also comprising a semiconducting junction that extends along a junction plane, the second and the third semiconducting zones (20, 30) each having a thickness in a direction transverse to said junction plane, and
in which the thickness of the third semiconducting zone (30) is more that the thickness of the second semiconducting zone (20), the thickness of the third semiconducting zone (30) preferably being more than twice or even three times the thickness of the second semiconducting zone (20).

8. Structure (1) according to any one of claims 1 to 7, in which the band gap width of the third semiconducting zone (30) is less than the band gap width of the semiconducting material with a band gap width adapted to promote absorption of the electromagnetic radiation (λ) in which at least one of the first and second semiconducting zones (10, 20) is formed, the third semiconducting zone (30) preferably comprising a band gap width smaller than the band gap width of the first, second, fourth and fifth semiconducting zones(10, 20, 40, 50).

9. Structure (1) according to any one of claims 1 to 8, in which the first and second semiconducting zones (10, 20) are integrated into a semiconducting layer, the semiconducting layer comprising a first face and a second face, a first portion of the semiconducting layer extending from a part of the first face forming the first semiconducting zone (10), the remainder of the semiconducting layer forming the second semiconducting zone (20).

10. Structure (1) according to any one of claims 1 to 9, in which the third and fourth semiconducting zones (30, 40) are integrated into a semiconducting layer, the semiconducting layer comprising a first portion forming the fourth semiconducting zone (40), and the remainder of the semiconducting layer forming the third semiconducting zone (30).

11. Structure (1) according to any one of claims 1 to 8, in which each of the first to the fifth semiconducting zones (10, 20, 30, 40, 50) is formed from a corresponding semiconducting layer, the semiconducting zones (10, 20, 30, 40, 50) being brought into contact with each other through the faces of the semiconducting layers from which they are formed.

12. Structure (1) according to claim 11, in which at least part of the semiconducting layers forming the first to the fifth semiconducting zones (10, 20, 30, 40, 50) is spatially delimited by the walls of a mesa.

13. Method of fabrication of a structure (1) of the avalanche photodiode type, the method **being characterised in that** it comprises the following steps to:
- supply a first semiconducting zone (10) of a first type of conductivity for which the majority carriers are electrons, and with a first face intended to receive an electromagnetic radiation (λ) and a second face opposite the first face,
- supply a second semiconducting zone (20) called the multiplication zone, the concentration of majority carriers in the second semiconducting zone (20) being less than the concentration in the first semiconducting zone (10), said second semiconducting zone (20) being adapted to provide a multiplication of carriers by impact ionisation that is preponderant for electrons, the steps to supply the first and second semiconducting zones (10, 20) being done such that the second semiconducting zone (20) is in contact with the second face of the first semiconducting zone (10), at least either the first or the second semiconducting zone (10, 20) being formed from a semiconducting material with a band gap width adapted to promote absorption of the electromagnetic radiation (λ),
- supply a third semiconducting zone (30) and a fifth semiconducting zone (50),
- supply a fourth semiconducting zone (40) called the collection zone, said fourth semiconducting zone (40) being of a second type of conductivity for which the majority carriers are electrons and having a higher concentration of majority carriers than the second semiconducting zone (20),
in which the steps to supply the third and the fifth semiconducting zones (30, 50) are done such that the third and the fifth semiconducting zones (30, 50) are located between the second semiconducting zone (20) and the fourth semiconducting zone (40), the third semiconducting zone (30) having a lower concentration of majority carriers than that of the absorption semiconducting zone and those of the fourth and fifth semiconducting zones (40, 50), and the fifth semiconducting zone (50) being of the second type of conductivity and having a higher concentration of majority carriers than that of the multiplication semiconducting zone so as to create an electric field in the third semiconducting zone (30) without multiplication of carriers by impact ionisation.

14. Fabrication method according to claim 13, in which the step to supply the first semiconducting zone (10) is done prior to the steps to supply the second, the third, the fourth and the fifth semiconducting zones (20, 30, 40, 50)
and in which the corresponding and successive steps to supply the second, fifth, third and fourth semiconducting zones (20, 50, 30, 40) each consist of a step in which said zone is formed in contact with the previously formed semiconducting zone, the second semiconducting zone (20) being formed in contact with the first semiconducting zone (10).

15. Fabrication method according to claim 13, in which the step to supply the fourth zone is done prior to the steps to supply the first, second, third and fifth semiconducting zones (20, 30, 40, 50)
and in which the corresponding and successive steps to supply the third, possibly the fifth, the second and the first semiconducting zones (30, 50, 20, 10) each consist of a step in which said zone is formed in contact with the previously formed semiconducting zone, the third semiconducting zone being formed in contact with the fourth semiconducting zone (40).
